# EUROPEAN PATENT APPLICATION

(11) **EP 4 585 703 A1**
(43) Date of publication of application: **16.07.2025**
(21) Application number: 25150711.7
(22) Date of filing: 08.01.2025
(51) Int. Cl.: C21D 6/00, C21D 8/02, C21D 9/46, C22C 19/03, C22C 38/08, C23C 14/04, H10K 71/16, B21B 1/40, C23F 1/02, C21D 1/76, C21D 9/00, C21D 9/56, C23C 14/12

(54) **A METAL PLATE AND A METHOD FOR MANUFACTURING THE SAME, AND A METHOD FOR MANUFACTURING A METAL MASK**

(30) Priority: 10.01.2024 JP 2024001808; 07.11.2024 JP 2024195111
(71) Applicant: Dai Nippon Printing Co., Ltd., Tokyo 162-8001 (JP)
(72) Inventor: NAKAMURA, Yusuke, Tokyo, 1628001 (JP); ISHIKAWA, Goro, Tokyo, 1628001 (JP); YANO, Hiroshi, Tokyo, 1628001 (JP); NUMATA, Hiroshi, Tokyo, 1628001 (JP); OKA, Hiroki, Tokyo, 1628001 (JP)
(74) Representative: Müller-Boré & Partner Patentanwälte PartG mbB

(57) **Abstract**

Provided is a metal plate to be used for manufacturing a metal mask. In a graph in which an arbitrary position n in a width direction of the metal plate is plotted on a horizontal axis and in which a differential expansion rate En in a unit length L0 in a longitudinal direction is plotted on a vertical axis, a maximum inclination of the differential expansion rate E in a central portion in the width direction is 1.8 × 10⁻³/m or less, and the central portion is a portion that occupies 80% in the width direction excluding both side portions that each occupy 10% in the width direction.

## Description

### BACKGROUND OF THE INVENTION

### Field of the Invention

The present invention relates to a metal plate, a method for manufacturing the metal plate, and a method for manufacturing a metal mask.

### Description of the Related Art

In recent years, display devices used in portable devices such as smartphones and tablet PCs have been required to be high-definition, for example, required to have a pixel density of 500 ppi or more. A demand for portable devices to be compatible with ultra-high definition (UHD) has also been increased. In this case, display devices preferably have a pixel density of 800 ppi or more, for example.

Among display devices, organic EL display devices are receiving attention because of their good responsiveness, low power consumption, and high contrast. Known as a method for forming pixels of an organic EL display device is a method for forming pixels in a desired pattern using a metal mask in which through-holes arrayed in the desired pattern have been formed. Specifically, the metal mask is first brought into close contact with a substrate for an organic EL display device. Next, the metal mask and the substrate in close contact with each other are input together to a vapor deposition device, and a vapor deposition step of vapor-depositing an organic material on the substrate is performed. Pixels containing the organic material can thereby be formed on the substrate in a pattern corresponding to the pattern of through-holes in the metal mask.

Known as a method for manufacturing a metal mask is a method for forming through-holes in a metal plate by etching through use of the photolithography technology. For example, a first resist pattern is first formed on a first surface of a metal plate through exposure and development treatment, and a second resist pattern is formed on a second surface of the metal plate through exposure and development treatment. Next, a region of the first surface of the metal plate which is not covered by the first resist pattern is etched to form a first recess in the first surface of the metal plate. Thereafter, a region of the second surface of the metal plate which is not covered by the second resist pattern is etched to form a second recess in the second surface of the metal plate. On this occasion, etching is performed such that the first recess and the second recess communicate with each other. Through-holes extending through the metal plate can thereby be formed (see, for example, Japanese Patent Laid-Open No. 2014-148743).

A metal plate for producing a metal mask is produced by rolling a base material made of an iron alloy containing nickel, for example. Through-holes in the metal mask obtained are improved in dimensional accuracy as the metal plate is rolled more thinly. However, on the other hand, a wavy shape appears in no small part in the metal plate due to rolling.

The wavy shape of the metal plate affects a metal mask in no small part. Thus, a metal mask device in which a metal mask is pulled in a planar direction to bring about a state having no waves and is fixed to a frame is used in the vapor deposition step. Therefore, in order to precisely produce an organic EL display device having a high pixel density, the positional accuracy of the through-holes when the metal mask is installed on the frame is important.

The present invention has been made in view of the above-described problems and has an object to provide a metal plate that can improve the positional accuracy of through-holes when a metal mask is installed on a frame, a method for manufacturing the metal plate, and a method for manufacturing a metal mask through use of the metal plate.

### SUMMARY OF THE INVENTION

A metal plate according to one embodiment of the present disclosure is a metal plate to be used for manufacturing a metal mask, in which
in a graph in which an arbitrary position n in a width direction of the metal plate is plotted on a horizontal axis and in which a differential expansion rate En in a unit length L0 in a longitudinal direction is plotted on a vertical axis,
a maximum inclination of the differential expansion rate E in a central portion in the width direction is 1.8 × 10⁻³/m or less, and
the central portion is a portion that occupies 80% in the width direction excluding both side portions that each occupy 10% in the width direction.

A method for manufacturing a metal plate according to one embodiment of the present disclosure is a method for manufacturing a metal plate to be used for manufacturing a metal mask, the method including
a rolling step of rolling a base material to obtain the metal plate, in which
in the metal plate,
in a graph in which an arbitrary position n in a width direction of the metal plate is plotted on a horizontal axis and in which a differential expansion rate En in a unit length L0 in a longitudinal direction is plotted on a vertical axis,
a maximum inclination of the differential expansion rate E in a central portion in the width direction is 1.8 × 10⁻³/m or less, and
the central portion is a portion that occupies 80% in the width direction excluding both side portions that each occupy 10% in the width direction.

A method for manufacturing a metal mask according to one embodiment of the present disclosure is a method for manufacturing a metal mask, including:
a rolling step of rolling a base material to prepare a metal plate; and
an etching step of etching the metal plate to form the metal mask, in which
in the metal plate,
in a graph in which an arbitrary position n in a width direction of the metal plate is plotted on a horizontal axis and in which a differential expansion rate En in a unit length L0 in a longitudinal direction is plotted on a vertical axis,
a maximum inclination of the differential expansion rate E in a central portion in the width direction is 1.8 × 10⁻³/m or less, and
the central portion is a portion that occupies 80% in the width direction excluding both side portions that each occupy 10% in the width direction.

### ADVANTAGEOUS EFFECTS OF THE INVENTION

According to the present invention, a metal plate that can improve the positional accuracy of through-holes when a metal mask is installed on a frame, a method for manufacturing the metal plate, and a method for manufacturing a metal mask through use of the metal plate can be provided.

### BRIEF DESCRIPTION OF THE DRAWINGS

FIG. 1A is a perspective view of a metal plate of the present disclosure;
FIG. 1B is a cross-sectional view of the metal plate in FIG. 1A in a longitudinal direction;
FIG. 1C is a schematic view of an exposure step for the metal plate of the present disclosure;
FIG. 1D is a schematic view of an etching step for the metal plate of the present disclosure;
FIG. 1E is a top view of a metal mask in which distortion caused by a wavy shape is reflected;
FIG. 1F is a top view of a state where tension in the longitudinal direction is applied to the metal mask;
FIG. 1G is a top view of the metal plate in FIG. 1B when seen in plan view;
FIG. 1H is a conceptual diagram showing a relationship among lengths obtained when a surface of the metal plate in FIG. 1G is measured in the longitudinal direction at respective positions n in the width direction;
FIG. 1I is a graph in which an arbitrary position n in the width direction D1 in FIG. 1H is plotted on a horizontal axis and in which a differential expansion rate En in a unit length L0 in the longitudinal direction D2 is plotted on a vertical axis;
FIG. 2A is an outlined cross-sectional view showing an aspect of a rolling step;
FIG. 2B is an outlined cross-sectional view showing an aspect of an annealing step;
FIG. 3A is an outlined plan view showing a metal mask according to an embodiment of the present disclosure;
FIG. 3B is an outlined perspective view showing an aspect when a perforated region is seen from a second surface side;
FIG. 3C is a cross-sectional view of a cross-section I-I shown in FIG. 3B;
FIG. 3D is an outlined perspective view showing an aspect when the perforated region is seen from the second surface side;
FIG. 4A is an outlined schematic view for describing an example of a method for manufacturing a metal mask;
FIG. 4B is a diagram showing an example of a step of forming a resist film on a metal plate;
FIG. 4C is a diagram showing an example of a step of patterning the resist film;
FIG. 4D is a diagram showing an example of a first surface etching step;
FIG. 4E is a diagram showing an example of a second surface etching step;
FIG. 5 is a diagram showing a metal mask device according to an embodiment of the present disclosure; and
FIG. 6 is a cross-sectional view showing a vapor deposition device according to an embodiment of the present disclosure.

### DETAILED DESCRIPTION OF THE PREFERRED EMBODIMENT

Hereinafter, an embodiment of the present disclosure will be described with reference to the drawings. Note that in the drawings attached to the present specification, for convenience of ease of depiction and understanding, scale ratios, longitudinal and lateral dimensional ratios, and the like are exaggerated as appropriate by changing them from actual ones in some cases.

In the present specification and/or the present drawings, interpretation will be made as indicated below unless particularly described.

Terms that mean a substance on which a certain component is based may not be distinguished from each other only based on different names. For example, terms such as a "substrate", a "base material", a "plate", a "sheet", and a "film" are relevant to the above description.

Terms and/or numerals that mean shapes and/or geometric conditions are not necessarily limited to their strict definitions, but may be construed to include a range to a degree that similar functions may be expected. For example, terms such as "parallel" and/or "orthogonal" are relevant to the above-described terms. Values such as "values of length" and/or "values of angle" are relevant to the above-described numerals.

In some cases where a component is expressed as being "on", "under", "on an upper side of", "on a lower side of", "above", or "below" another component, the cases may include an aspect in which the component is in direct contact with the other component, and an aspect in which a different component is included between the component and the other component. In other words, the aspect in which a different component is included between the component and the other component may be expressed as the component and the other component being in indirect contact with each other. The expression "on", "upper side", or "above" can be exchanged to the expression "under", "lower side", or "below". In other words, an up-down direction may be reversed.

Identical portions and/or portions that have a similar function are designated by identical reference characters or like reference characters, and repeated description is omitted in some cases. The ratio of dimensions in the drawings differs from an actual ratio in some cases. Illustration of some components of an embodiment is omitted in the drawings in some cases.

One or more embodiments and one or more modifications may be combined within a range where no contradiction occurs. One or more embodiments may be combined within a range where no contradiction occurs. One or more modifications may be combined within a range where no contradiction occurs.

In a case where a plurality of steps are disclosed in relation to a method such as a manufacturing method, another undisclosed step may be performed between the disclosed steps. The order of the steps is not limited within a range where no contradiction occurs.

A numeral range expressed by the word "to" includes numerals placed in front of and behind the word "to". For example, a numeral range expressed as "34 to 38 mass %" is identical to a numeral range expressed as "34 mass % or more and 38 mass % or less".

A numeral range of a numeral described in the present disclosure may be defined by combining an arbitrary one of a plurality of upper-limit candidate values and an arbitrary one of a plurality of lower-limit candidate values. Besides, any two of the plurality of upper-limit candidate values may be combined to define the numeral range, or any two of the plurality of lower-limit candidate values may be combined to define the numeral range without particular mention.

One embodiment of the present disclosure will be described in the following paragraphs. One embodiment of the present disclosure is an example of embodiments of the present disclosure. The present disclosure is not construed as being limited only to the one embodiment of the present disclosure.

The metal plate of the present disclosure is a metal plate which is elongated and is to be used for manufacturing a metal mask. The metal mask can be used for various applications. Although not particularly limited, the metal mask can be used as, for example, a metal mask to be used for patterning an organic material on a substrate in a desired pattern in manufacturing of an organic EL display device. The metal mask is also called a vapor deposition mask. The metal mask of the present disclosure enables patterning at a high pixel density. Organic EL display devices that can be manufactured include not only displays of a smartphone, a television, and the like, but also devices for displaying or projecting an image or video for expressing virtual reality (VR) or augmented reality (AR).

A first aspect of the present disclosure is a metal plate to be used for manufacturing a metal mask, in which in a graph in which an arbitrary position n in a width direction of the metal plate is plotted on a horizontal axis and in which a differential expansion rate En in a unit length L0 in a longitudinal direction is plotted on a vertical axis,
a maximum inclination of the differential expansion rate E in a central portion in the width direction is 1.8 × 10⁻³/m or less, and
the central portion is a portion that occupies 80% in the width direction excluding both side portions that each occupy 10% in the width direction.

A second aspect of the present disclosure is the metal plate of the first aspect described above, in which a maximum value of the differential expansion rate En in the central portion in the width direction is 2.5 × 10⁻⁵ or less.

A third aspect of the present disclosure is the metal plate of the first aspect or the second aspect described above, in which a maximum value of the differential expansion rate En in the side portions is 2.5 × 10⁻⁵ or more.

A fourth aspect of the present disclosure is the metal plate of any of the first to third aspects described above, in which the metal plate has a thickness of 50 µm or less.

A fifth aspect of the present disclosure is the metal plate of any of the first to fourth aspects described above, in which the unit length L0 in the longitudinal direction of the metal plate is 0.5 m or more and 3.0 m or less.

A sixth aspect of the present disclosure is a method for manufacturing a metal plate to be used for manufacturing a metal mask, the method including
a rolling step of rolling a base material to obtain the metal plate, in which
in the metal plate,
in a graph in which an arbitrary position n in a width direction of the metal plate is plotted on a horizontal axis and in which a differential expansion rate En in a unit length L0 in a longitudinal direction is plotted on a vertical axis,
a maximum inclination of the differential expansion rate E in a central portion in the width direction is 1.8 × 10⁻³/m or less, and
the central portion is a portion that occupies 80% in the width direction excluding both side portions that each occupy 10% in the width direction.

A seventh aspect of the present disclosure is a method for manufacturing a metal mask, including:
a rolling step of rolling a base material to prepare a metal plate; and
an etching step of etching the metal plate to form the metal mask, in which
in the metal plate,
in a graph in which an arbitrary position n in a width direction of the metal plate is plotted on a horizontal axis and in which a differential expansion rate En in a unit length L0 in a longitudinal direction is plotted on a vertical axis,
a maximum inclination of the differential expansion rate E in a central portion in the width direction is 1.8 × 10⁻³/m or less, and
the central portion is a portion that occupies 80% in the width direction excluding both side portions that each occupy 10% in the width direction.

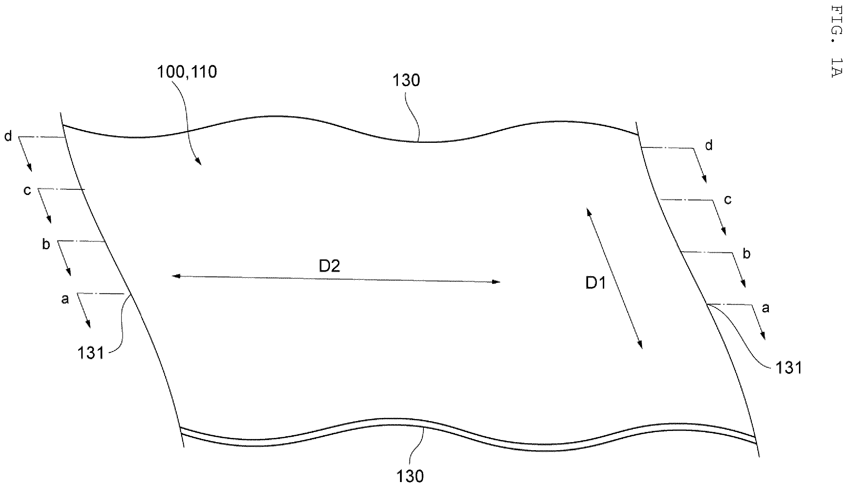

As a premise for describing a configuration of a metal plate of the present disclosure, an outline of steps for manufacturing a metal mask device 10 from a metal plate 100 is first shown in FIG. 1A to FIG. 1F.

As shown in FIG. 1A, the rolled metal plate 100 which may have a wavy shape at least partially is assumed. As the metal plate is rolled more thinly from the viewpoint of improving the dimensional accuracy of through-holes, a wavy shape appears in no small part in the metal plate due to rolling. Such a wavy shape results from a fact that the length of the metal plate 100 in a longitudinal direction D2 differs depending on the position in a width direction D1. Note that the metal plate 100 may have two sides 131 parallel to the width direction D1 and two side edges 130 parallel to the longitudinal direction D2.

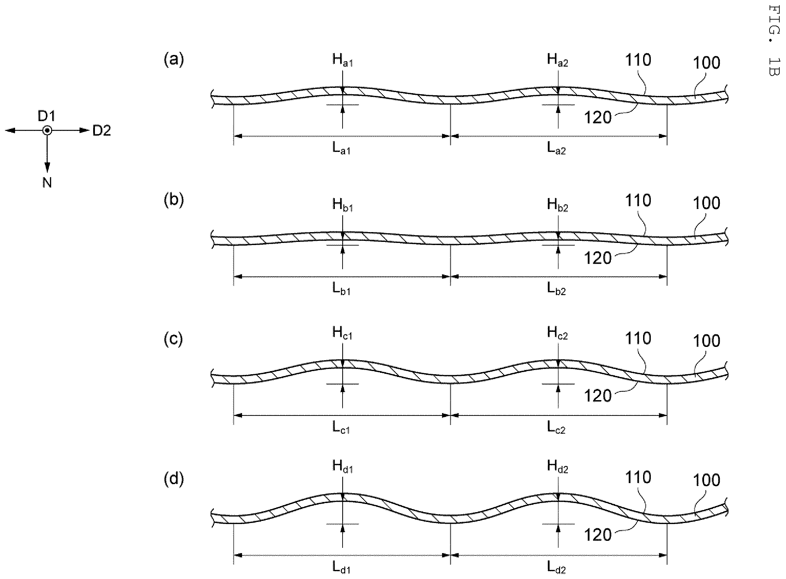

FIG. 1B is a cross-sectional view of the metal plate 100 in FIG. 1A in the longitudinal direction D2. Respective cross-sectional views (a) to (d) in FIG. 1B are cross-sectional views taken along lines a-a, b-b, c-c, and d-d in FIG. 1A. All of the lines a-a, b-b, c-c, and d-d are lines parallel to the longitudinal direction D2.

In the aspect shown in FIG. 1B, the cross-sectional view (d) passing through a place close to the side edge 130 is the waviest. As is apparent from a comparison among the cross-sectional views (b) to (d), the cross-sectional views gradually become less wavy from the side edge 130 in the width direction D1 toward the center. As is apparent from a comparison between the cross-sectional views (b) and (a), the cross-sectional view (a) is slightly wavier.

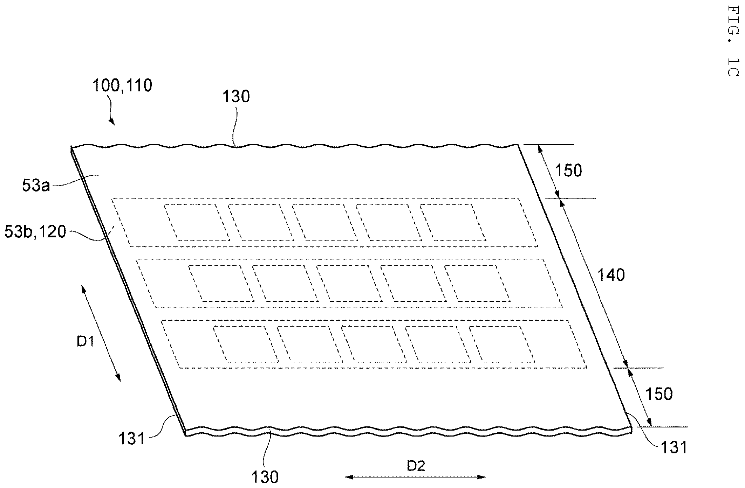

On such a metal plate 100, a first resist film 53a is formed on a first surface 110 of the metal plate 100, and a second resist film 53b is formed on a second surface 120, as shown in FIG. 1C, and exposure is performed. In this exposure step, exposure masks are brought into close contact with a first resist pattern 53c and a second resist pattern 53d on the metal plate 100 through vacuum adsorption or the like. Therefore, as shown in FIG. 1C, the wavy shape of the metal plate 100 is compressed in the exposure step, and the metal plate 100 is brought into a substantially flat state.

In this flattened state, the exposure step is performed, and by conducting the development step, a predetermined resist pattern is formed so as to define outer shapes of the metal masks 20 in portions indicated by broken lines in FIG. 1C. The portions corresponding to the metal masks in the resist pattern may be formed in a central portion 140 having a relatively less wavy shape. Note that in the present disclosure, a range of ±40% from the central position in the width direction D1 is referred to as the central portion 140, and ranges from ends of the central portion 140 to the side edges 130 are referred to as side portions 150. In other words, the central portion 140 is a portion excluding both the side portions 150 that each occupy 10% in the width direction D1 of the metal plate 100, and the central portion 140 is a portion that occupies 80% in the width direction D1.

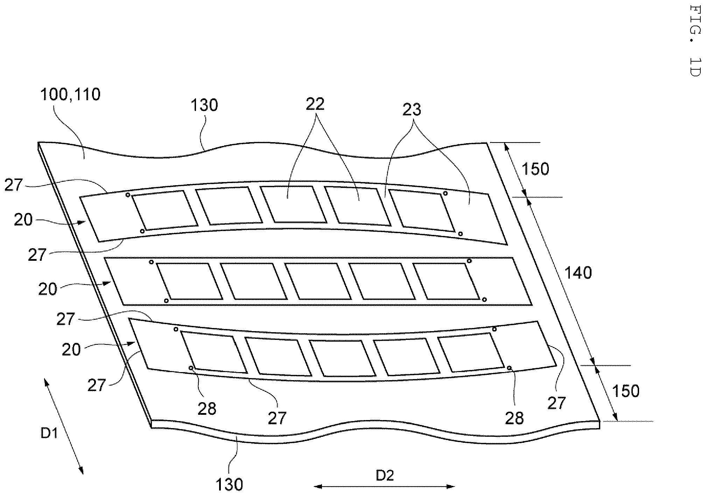

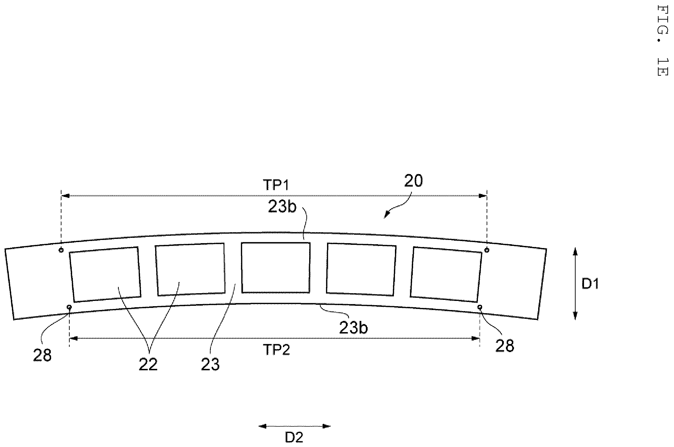

Next, FIG. 1D shows an outlined perspective view of an etching step through the resist pattern. In the etching step, the exposure mask has been removed from the metal plate 100, and the wavy shape is restored to the degree shown in FIG. 1A. Therefore, when etching is performed in the state where the wavy shape has been restored as shown in FIG. 1D, the outer shape 27 of the obtained metal mask 20 also has a shape reflecting the wavy shape as shown in FIG. 1E. Specifically, the outer shape 27 of the metal mask 20 is likely to be curved to the side having a wavier shape (the side closer to the side edge 130).

When the distortion caused by the wavy shape is reflected in this manner, the metal mask 20 obtained varies in size. The variation can be evaluated by total pitch marks 28 as shown in FIG. 1E.

The total pitch mark 28 may be arranged at a corner of each of the perforated regions 22 or may be arranged in a peripheral region 23 in the vicinity of a corner of each of the perforated regions 22. The total pitch mark 28 may be formed in a recessed manner at a desired position of the first surface 20a or the second surface 20b by half-etching in the etching step, or may be formed as a through-hole. The total pitch mark 28 may have, but is not particularly limited to, a circular, rectangular, or another planar shape, for example.

Using two of these total pitch marks 28 that are separate from each other in the longitudinal direction D2 as reference points, a linear distance between the two total pitch marks 28 is measured. By measuring linear distances TP1 and TP2 in the longitudinal direction D2 between the total pitch marks 28 as described above and calculating the difference between the linear distances TP1 and TP2, distortion of the metal mask 20 can be quantitated.

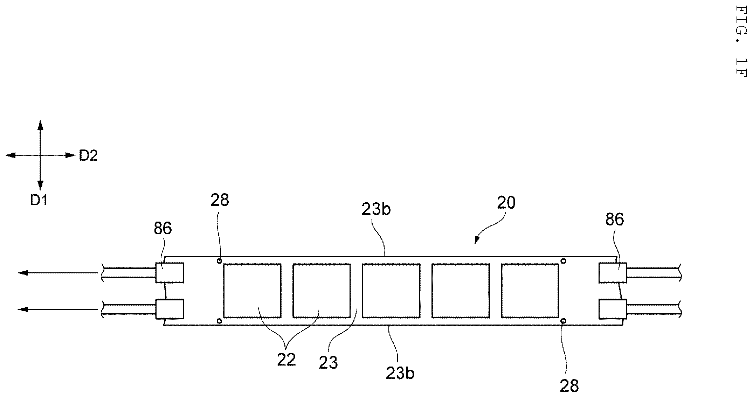

FIG. 1F shows a schematic view immediately before the metal mask 20 is installed on the frame 15. When the metal mask 20 is installed on the frame 15, tension in the longitudinal direction D2 is applied to the metal mask 20 with clamps 86 or the like as shown in FIG. 1F. At this time, tension is applied such that the linear distances TP1 and TP2 in the longitudinal direction D2 between the total pitch marks 28 are substantially equal to each other. The metal mask 20 is thereby installed on the frame 15 in a flat state.

However, as the metal masks 20 differ in shape to a greater degree, tension adjustment needs to be performed more finely for each of the metal masks 20 to ensure the positional accuracy. Consequently, even if the metal plate 100 has a wavy shape, it is preferable that variation in the wavy shape should be reduced. The positional accuracy of the through-holes when the metal mask 20 is installed on the frame 15 can thereby be improved.

Thus, the present disclosure defines that in a graph in which the arbitrary position n in the width direction D1 of the metal plate 100 is plotted on the horizontal axis and in which the differential expansion rate En in the unit length L0 in the longitudinal direction D2 is plotted on the vertical axis, the maximum inclination of the differential expansion rate E in the central portion 140 in the width direction D1 is 1.8 × 10⁻³/m or less.

Changes in the differential expansion rate En at the arbitrary position n in the width direction D1 of the metal plate 100 thereby decrease. Accordingly, even in a case in which the metal mask 20 having an arbitrary width is cut out from the metal plate 100 as shown in FIG. 1E, the difference in outer shape among the individual metal masks 20 decreases, which improves uniformity in quality. In other words, the metal mask 20 thus obtained has good positional accuracy of the through-holes when installed on the frame 15.

The maximum inclination of the differential expansion rate E of the present disclosure is 1.8 × 10⁻³/m or less, preferably may be 1.7 × 10⁻³/m or less, may be 1.6 × 10⁻³/m or less, or may be 1.5 × 10⁻³/m or less. The maximum inclination of the differential expansion rate E is, but not particularly limited to, 0/m or more, may be 0.1 × 10⁻³/m or more, may be 0.2 × 10⁻³/m or more, may be 0.3 × 10⁻³/m or more, may be 0.4 × 10⁻³/m or more, may be 0.5 × 10⁻³/m or more, may be 0.6 × 10⁻³/m or more, may be 0.7 × 10⁻³/m or more, may be 0.8 × 10⁻³/m or more, may be 0.9 × 10⁻³/m or more, or may be 1.0 × 10⁻³/m or more.

The maximum inclination of the differential expansion rate E may be determined by a combination of an arbitrary one of the above-described plurality of lower-limit candidate values and an arbitrary one of the above-described plurality of upper-limit candidate values. As such an example, the range of the maximum inclination of the differential expansion rate E may be 0.1 × 10⁻³/m or more and 1.8 × 10⁻³/m or less, may be 0.2 × 10⁻³/m or more and 1.7 × 10⁻³/m or less, or may be 0.3 × 10⁻³/m or more and 1.6 × 10⁻³/m or less.

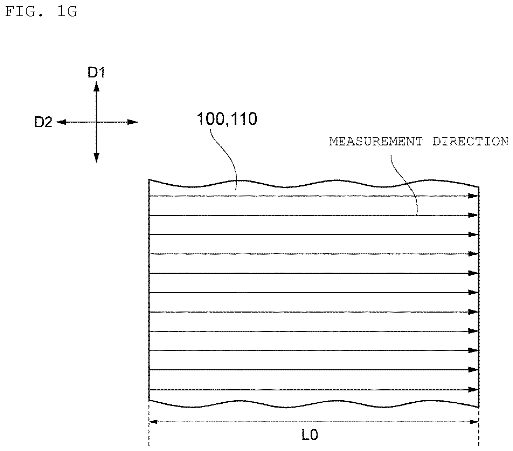

Hereinafter, "the graph in which the arbitrary position n in the width direction D1 is plotted on the horizontal axis and in which the differential expansion rate E in the unit length L0 in the longitudinal direction D2 is plotted on the vertical axis" and "the maximum inclination of the differential expansion rate E" will be described in more detail with reference to FIG. 1G to FIG. 1I.

In the present disclosure, the differential expansion rate En in the unit length L0 in the longitudinal direction D2 for the arbitrary position n in the width direction D1 of the metal plate 100 is measured. In other words, the differential expansion rate En is measured from a wavy shape taken at the arbitrary position n in the width direction D1, such as the cross-sectional views (a) to (d) shown in FIG. 1B. In FIG. 1B(a) to (d), for example, two waves represented by periods La to Ld at heights Ha to Hd are shown in the unit length L0 as an illustration. The number of waves per unit length L0 is not particularly limited and may be one or may be three or more.

In the present disclosure, "the unit length L0" indicates a length in the longitudinal direction D2 when the differential expansion rate En of the present disclosure is measured. Note that from the viewpoint of considering an influence of the differential expansion rate En on the metal mask 20, the unit length L0 may be a length equivalent to the length of the metal mask 20 in the longitudinal direction. For example, the unit length L0 may be preferably 0.5 m or more and 3.0 m or less, or may be 1.0 m or more and 1.8 m or less. The unit length L0 may be 500 mm, may be 750 mm, may be 980 mm, may be 1280 mm, may be 1648 mm, or may be 3000 mm, for example. Note that the unit length L0 refers to a length of the metal plate 100 when seen in plan view.

Note that each of the values concerning the differential expansion rate, such as the maximum inclination of the differential expansion rate E, the maximum value of the differential expansion rate En in the central portion, and the maximum values of the differential expansion rates in both the side portions in the present disclosure, is preferably satisfied by the above-described unit length L0, and is preferably satisfied by 750 mm, 1280 mm, and 3000 mm.

FIG. 1G is a top view of the metal plate 100 in FIG. 1A when seen in plan view. The metal plate 100 having the unit length L0 when seen in the top view actually has a wavy shape such as that of the cross-sectional views (a) to (d) shown in FIG. 1B. Therefore, the surface length of the metal plate 100 along the wavy shape is longer than the unit length L0.

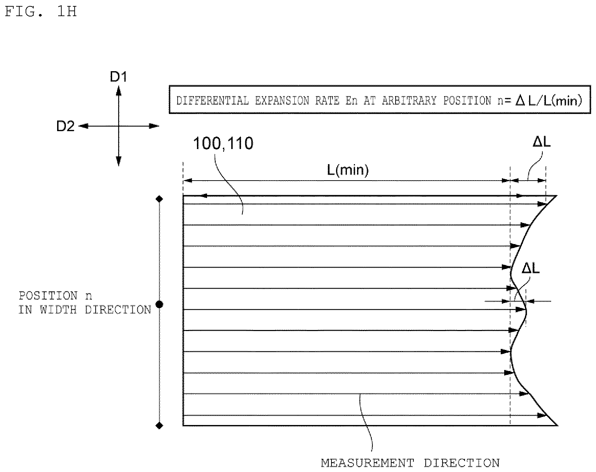

FIG. 1H is a conceptual diagram showing a relationship among lengths obtained when a first surface 110 of the metal plate 100 in FIG. 1G is measured in the longitudinal direction D2 at the respective positions n in the width direction. FIG. 1H shows the lengths obtained when a surface length Ln of the metal plate 100 along the wavy shape is measured in the longitudinal direction D2 at the positions n in the width direction. The surface length Ln of the metal plate 100 along the wavy shape can be thought of as the length of the metal plate 100 in the longitudinal direction D2 to be obtained when the metal plate 100 is pulled in the longitudinal direction D2 to flatten the waves.

Herein, the "differential expansion rate" in the present disclosure is a value calculated from a minimum value L(min) of Ln and a difference ΔLn between L(min) and Ln by the following equation. The degree of the wavy shape can be evaluated by the differential expansion rate En.: Differential expansion rate En at position n = ΔLn/L(min)

For example, a sample of the metal plate 100 which is 500 mm in the width direction and 1280 mm (the unit length L0) in the longitudinal direction is assumed. When a surface of this sample is measured in the longitudinal direction D2, the minimum value L(min) shall be 1280.1352 mm at a location of +75 mm from the center. At this time, L shall be 1280.1612 mm at a location of +0 mm from the center, and ΔL shall be 26.0 µm. Based on this premise, the differential expansion rate E at the location of +0 mm from the center is calculated as 2.0 × 10⁻⁵ (= 26.0 µm/1280.1352 mm). Note that the above-described example is a numerical illustration for describing the differential expansion rate in the present disclosure and has no relation with examples of the metal plate and the like of the present disclosure.

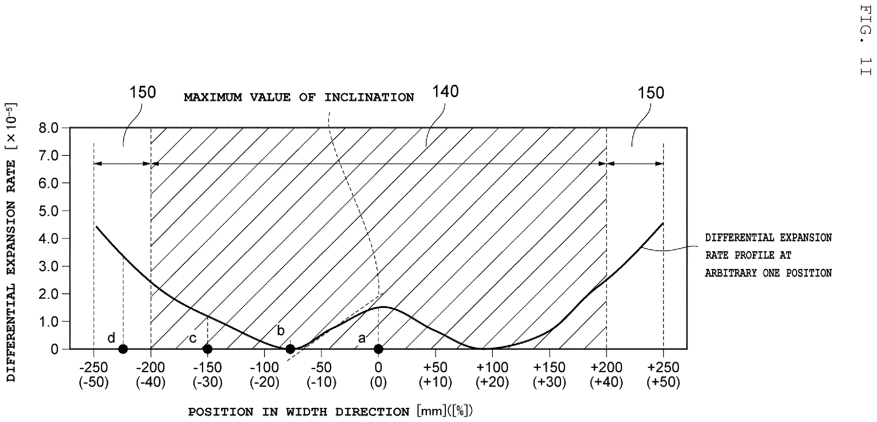

FIG. 1I shows a graph in which the arbitrary position n in the width direction D1 is plotted on the horizontal axis and in which the differential expansion rate En in the unit length L0 in the longitudinal direction D2 is plotted on the vertical axis. In FIG. 1I, the horizontal axis indicates the positions in the width direction D1 of the metal plate 100. The differential expansion rate En at each position n in the width direction of the metal plate can be recognized from this graph.

FIG. 1I shows the metal plate 100 having a width of 500 mm by coordinates of ±250 mm (±50%) to the side edges 130 on the horizontal axis on which a central position in the width direction D1 is located at 0 mm (0%). Points a to d in FIG. 1I indicate the respective positions of the lines a-a, b-b, c-c, and d-d in the width direction D1, respectively. Changes in the differential expansion rate En in the width direction D1 in the metal plate 100 can be depicted by FIG. 1I. A graph showing changes in the differential expansion rate En in the width direction D1 in the metal plate 100 as shown in FIG. 1I or data indicating the changes is also called a "differential expansion rate profile" in the present disclosure.

Note that the point a is positioned at the center (0 mm [0%]) of the metal plate 100 in the width direction D1. The point d is positioned (-225 mm [-45%]) on the side edge 130 side of the metal plate 100 in the width direction D1. The points b and c are positioned respectively at internally dividing points (-75 mm [-15%] and -150 mm [-30%]) which equally divide a range between the point a and the point **d.** Note that the width of 500 mm of the metal plate 100 in FIG. 1I is merely an illustration, and the metal plate 100 may have a larger width or a smaller width.

In the present disclosure, a range of ±40% from the central position in the width direction D1 is referred to as the central portion 140, and ranges from ends of the central portion 140 to the side edges 130 are referred to as the side portions 150. In other words, the central portion 140 is a portion excluding both the side portions 150 that each occupy 10% in the width direction D1 of the metal plate 100, and the central portion 140 is a portion that occupies 80% in the width direction D1. The vertical axis indicates the differential expansion rate En at the arbitrary position n in the width direction D1 of the metal plate 100.

The differential expansion rate profile has a tendency that a local maximum value of the differential expansion rate En appears (the point a) in the vicinity of the central portion 140 of the metal plate 100 in the width direction as shown in FIG. 1I. A local minimum value of the differential expansion rate En appears (the point b) at a position slightly away from the central portion 140 of the metal plate 100 in the width direction to the side edge 130. The differential expansion rate En increases (the point c) from the point b toward the side edge 130 in the width direction D1, and the value of the differential expansion rate En is maximized (the point d) at the side edge 130 in the width direction D1. However, the shape of the differential expansion rate profile is not limited to this.

In the present disclosure, "the maximum inclination of the differential expansion rate E" is a value which is the maximum among inclinations of the central portion 140 in the graph as shown in FIG. 1I. A smaller maximum inclination of the differential expansion rate E means that a greater change in differential expansion rate E is not caused in the central portion 140, and even in the case in which the metal mask 20 having an arbitrary width is cut out from the metal plate 100, the difference in outer shape among the individual metal masks 20 decreases, which improves uniformity in quality. In other words, the metal mask 20 thus obtained has good positional accuracy of the through-holes when installed on the frame 15.

The maximum value of the differential expansion rate En in the central portion 140 in the width direction D1 preferably may be 2.5 × 10⁻⁵ or less, may be 2.4 × 10⁻⁵ or less, may be 2.3 × 10⁻⁵ or less, or may be 2.2 × 10⁻⁵ or less. Note that a position at which the differential expansion rate En is maximized in the central portion 140 in the width direction is not particularly restricted, and as an example, may be positioned at the point a (0 mm [0%]) or a boundary (±200 mm [±40%]) between the central portion 140 and the side portion 150 in the example shown in FIG. 1G.

The lower limit of the maximum value of the differential expansion rate En in the central portion 140 in the width direction is not particularly restricted, and the smaller the lower limit, the more preferable it is. As an example, the differential expansion rate En may be 0 or more, may be 1.0 × 10⁻⁸ or more, may be 2.5 × 10⁻⁸ or more, may be 5.0 × 10⁻⁸ or more, may be 7.5 × 10⁻⁸ or more, may be 1.0 × 10⁻⁷ or more, may be 2.5 × 10⁻⁷ or more, may be 5.0 × 10⁻⁷ or more, may be 1.0 × 10⁻⁶ or more, may be 2.5 × 10⁻⁶ or more, may be 7.5 × 10⁻⁶ or more, or may be 1.0 × 10⁻⁵ or more.

The range of the maximum value of the differential expansion rate En in the central portion 140 in the width direction may be determined by a combination of an arbitrary one of the above-described plurality of lower-limit candidate values and an arbitrary one of the above-described plurality of upper-limit candidate values. As such an example, the maximum value of the differential expansion rate En in the central portion 140 in the width direction preferably may be 0 or more and 2.5 × 10⁻⁵ or less, may be 1.0 × 10⁻⁸ or more and 2.4 × 10⁻⁵ or less, may be 2.5 × 10⁻⁸ or more and 2.3 × 10⁻⁵ or less, or may be 5.0 × 10⁻⁸ or more and 2.2 × 10⁻⁵ or less.

Each of the maximum values of the differential expansion rates En in the two side portions 150 in the width direction D1 is preferably larger than the maximum value of the differential expansion rate En in the central portion 140 in the width direction D1. It is assumed that as shown in FIG. 1C, the metal plate 100 with the resist films is held by two exposure masks and the exposure masks are brought into close contact with the first resist pattern 53c and the second resist pattern 53d on the metal plate 100, respectively, through vacuum adsorption or the like. In this case, since the maximum values of the differential expansion rates En in the side portions 150 are larger than the maximum value of the differential expansion rate En in the central portion 140, an escape route of air present in the vicinity of the central portion 140 of the metal plate 100 can be reliably ensured, and the exposure masks can be sufficiently brought into close contact with the first resist pattern 53c and the second resist pattern 53d, respectively, across the entire area. In addition, buckling breakage that the metal plate 100 is broken along its longitudinal direction and deflection that the metal plate 100 is displaced from a transfer direction are less likely to occur during transfer.

The maximum values of the differential expansion rates En in the two side portions 150 in the width direction D1 preferably may be 2.5 × 10⁻⁵ or more, may be 3.0 × 10⁻⁵ or more, may be 3.5 × 10⁻⁵ or more, may be 4.0 × 10⁻⁵ or more, or may be 4.5 × 10⁻⁵ or more. The maximum values of the differential expansion rates En in the two side portions 150 in the width direction D1 preferably may be 8.0 × 10⁻⁵ or less, may be 7.5 × 10⁻⁵ or less, may be 7.0 × 10⁻⁵ or less, may be 6.5 × 10⁻⁵ or less, or may be 6.0 × 10⁻⁵ or less.

A range of the maximum values of the differential expansion rates En in the two side portions 150 in the width direction D1 may be determined by a combination of an arbitrary one of the above-described plurality of lower-limit candidate values and an arbitrary one of the above-described plurality of upper-limit candidate values. As such an example, the maximum values of the differential expansion rates En in the two side portions 150 in the width direction D1 preferably may be 2.5 × 10⁻⁵ or more and 8.0 × 10⁻⁵ or less, may be 3.0 × 10⁻⁵ or more and 7.5 × 10⁻⁵ or less, may be 3.5 × 10⁻⁵ or more and 7.0 × 10⁻⁵ or less, may be 4.0 × 10⁻⁵ or more and 6.5 × 10⁻⁵ or less, or may be 4.5 × 10⁻⁵ or more and 6.0 × 10⁻⁵ or less.

The maximum values of the differential expansion rates En in the two side portions 150 preferably may be 1.8 or more times, may be 1.9 or more times, may be 2.0 or more times, may be 2.1 or more times, may be 2.2 or more times, or may be 2.3 or more times the maximum value of the differential expansion rate En in the central portion 140.

The maximum values of the differential expansion rates En in the two side portions 150 preferably may be 3.2 or less times, may be 3.1 or less times, may be 3.0 or less times, may be 2.9 or less times, may be 2.8 or less times, or may be 2.7 or less times the maximum value of the differential expansion rate En in the central portion 140.

A ratio of the maximum values of the differential expansion rates En in the side portions 150 to the maximum value of the differential expansion rate En in the central portion 140 may be determined by a combination of an arbitrary one of the above-described plurality of lower-limit candidate values and an arbitrary one of the above-described plurality of upper-limit candidate values. As such an example, the maximum values of the differential expansion rates En in the two side portions 150 preferably may be 1.8 or more times and 3.2 or less times, may be 1.9 or more times and 3.1 or less times, may be 2.0 or more times and 3.0 or less times, may be 2.1 or more times and 2.9 or less times, may be 2.2 or more times and 2.8 or less times, or may be 2.3 or more times and 2.7 or less times the maximum value of the differential expansion rate En in the central portion 140.

Note that at least one of the differential expansion rates En in the two side portions 150 preferably satisfies the above-described range, or both of them preferably satisfy the above-described range.

The metal plate 100 is not particularly restricted in size and thickness in the width direction D1 and the longitudinal direction D2. The metal plate 100 may be an elongated metal plate, or may be a short metal plate configured by, for example, being cut out from an elongated metal plate into a predetermined length.

A length of the metal plate 100 in the width direction D1 preferably may be 200 mm or more, may be 300 mm or more, may be 350 mm or more, may be 400 mm or more, may be 450 mm or more, or may be 500 mm or more. The length of the metal plate 100 in the width direction D1 preferably may be 800 mm or less, may be 750 mm or less, may be 700 mm or less, may be 650 mm or less, may be 600 mm or less, or may be 550 mm or less. The length of the metal plate 100 in the width direction D1 preferably may be 300 mm to 800 mm, may be 350 mm to 750 mm, may be 400 mm to 700 mm, or may be 450 mm to 650 mm.

A total length of the metal plate 100 in the longitudinal direction D2 in the short case preferably may be 0.5 m or more, may be 1.0 m or more, or may be 1.2 m or more. The total length of the metal plate 100 in the longitudinal direction D2 in the short case preferably may be 5.0 m or less, may be 4.0 m or less, may be 3.0 m or less, or may be 2.0 m or less. The total length of the metal plate 100 in the longitudinal direction D2 in the short case preferably may be 0.5 m to 5.0 m, may be 0.5 m to 3.0 m, or may be 1.0 m to 1.8 m.

The total length of the metal plate 100 in the longitudinal direction D2 in the elongated case preferably may be 50 m or more, may be 100 m or more, may be 150 m or more, may be 200 m or more, may be 300 m or more, may be 400 m or more, or may be 500 m or more. The total length of the metal plate 100 in the longitudinal direction D2 in the elongated case preferably may be 1200 m or less, may be 1000 m or less, may be 800 m or less, may be 700 m or less, or may be 600 m or less. The total length of the metal plate 100 in the longitudinal direction D2 in the elongated case preferably may be 50 m to 1200 m, may be 50 m to 1000 m, may be 50 m to 800 m, or may be 100 m to 800 m.

A thickness of the metal plate 100 preferably may be 100 µm or less, may be 50 µm or less, may be 45 µm or less, may be 40 µm or less, may be 35 µm or less, may be 30 µm or less, may be 25 µm or less, or may be 20 µm or less. The thickness of the metal plate 100 preferably may be 2.5 µm or more, may be 5 µm or more, may be 10 µm or more, or may be 15 µm or more. The thickness of the metal plate 100 preferably may be 2.5 to 100 µm, may be 5 to 50 µm, or may be 10 to 40 µm. Reducing the thickness enables the perforated region 22 of the metal mask 20 which will be described later to be configured more thinly, which leads to a tendency that a vapor deposition material 98 can be prevented from adhering to a second wall surface 36 of a second recess 35 in the vapor deposition step. Increasing the thickness leads to a tendency that the strength of the metal mask 20 is further improved. This leads to a tendency that the perforated region 22 can be prevented from being deformed or broken, for example.

Note that when reducing the thickness, increasing a rolling rate in the rolling step in the method for manufacturing the metal plate 100 is considered. However, when the rolling rate is simply increased, the degree of non-uniformity of rolling-based deformation is likely to be increased, so that the wavy shape is likely to occur.

A material constituting the metal plate 100 can include, for example, but is not particularly limited to, an iron alloy containing nickel, an iron alloy containing chromium, such as stainless steel, nickel, a nickel-cobalt alloy, or the like.

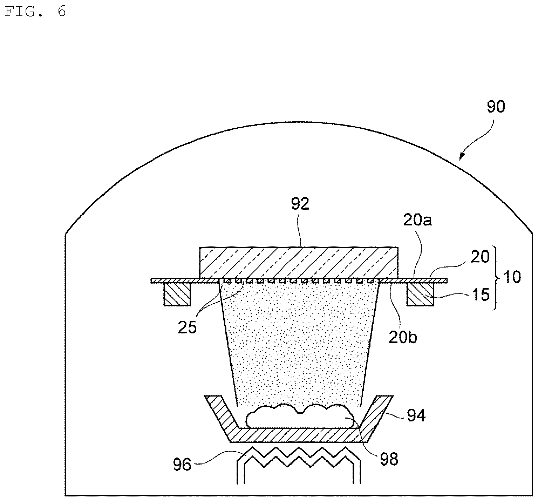

Among them, an iron alloy containing nickel is preferable. Through use of an iron alloy containing nickel, the thermal expansion coefficient of the metal mask 20 to be obtained from the metal plate 100 can have a value equivalent to the thermal expansion coefficient of the frame 15 and the thermal expansion coefficient of a substrate 92 (see FIG. 6). This can prevent an occurrence of misalignment resulting from differences in dimensional change among the metal mask 20, the frame 15, and the substrate 92 during vapor deposition treatment. It is therefore possible to prevent degradation in dimensional accuracy and positional accuracy of the vapor deposition material 98 adhering to the substrate 92 that would result from the misalignment.

The iron alloy containing nickel can include, for example, but is not particularly limited to, an iron alloy containing 30 mass % or more and 54 mass % or less nickel, such as a super-invar material further containing cobalt in addition to 30 mass % or more and 34 mass % or less nickel, an invar material containing 34 mass % or more and 38 mass % or less nickel, or a low thermal expansion Fe-Ni-based plating alloy containing 48 mass % or more and 54 mass % or less nickel.

Next, a method for manufacturing the metal plate of the present disclosure will be described. The method for manufacturing the metal plate of the present disclosure is a method for manufacturing the metal plate having the above-described maximum value of the inclination in the differential expansion rate En, includes the rolling step of rolling a base material to obtain the metal plate 100, and may include a slitting step of cutting both ends of the metal plate 100 and an annealing step of heat-treating the metal plate 100 according to necessity.

The rolling step is a step of rolling a base material 55 to obtain the metal plate 100. A rolling method can include, for example, but is not particularly limited to, a rolling method through use of a pair of rolling rolls 56a, 56b that roll the base material 55 in the thickness direction. The base material 55 can include, for example, but is not particularly limited to, an iron alloy containing nickel.

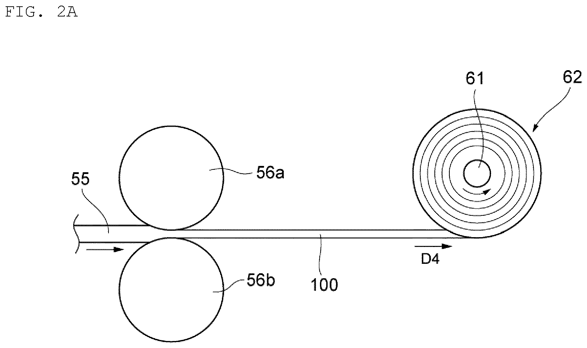

FIG. 2A shows an outlined cross-sectional view of the rolling step. First, the base material 55 is transferred to the rolling rolls 56a, 56b in a direction D4. The base material 55 is rolled by the pair of rolling rolls 56a, 56b. As a result, the base material 55 is reduced in thickness and extended in the transfer direction. The metal plate 100 is thereby obtained. The metal plate 100 may be rolled up around a core 61 to form a rolled body 62.

Note that FIG. 2A merely shows an outline of the rolling step, and a specific configuration and procedure for carrying out the rolling step are not particularly limited. For example, the rolling step may include a hot-rolling step of processing the base material at a temperature of or above a recrystallization temperature of the invar material constituting the base material 55 or a cold-rolling step of processing the base material at a temperature of or below the recrystallization temperature of the invar material. FIG. 2A illustrates transferring the base material 55 in the right direction of the sheet of drawing, the transfer direction of the base material at the time of rolling is not limited to this, and the base material 55 may be transferred in the left direction of the sheet of drawing. Alternatively, the base material 55 may be transferred to reciprocate to right and left between the rolling rolls 56a, 56b and may be rolled in that process.

In the rolling step, the base material 55 may be rolled to a desired thickness at one time, or may be rolled to a desired thickness by carrying out the rolling step a plurality of times at a predetermined rolling rate. During rolling, a rolling oil or the like may be used according to necessity.

From the viewpoint of adjusting the maximum value of the inclination of the differential expansion rate En and the maximum value of the differential expansion rate En in the central portion 140 in the width direction of the metal plate 100 of the present disclosure, uniformity of pressing force fluctuation and uniformity of a pressing force distribution may be adjusted.

From the viewpoint of obtaining the metal plate 100 with the wavy shape reduced, it is preferable that the pressing force should be constant without fluctuating. However, the base material partially has a hard metal tissue or partially has a large thickness in some cases. Therefore, a pressing force applied to the rolls that roll the base material fluctuates along with the passage of the base material. In order to reduce such a fluctuation in the pressing force, a method such as increasing the number of rolls or providing an adjustment mechanism for keeping the pressing force constant can be used. This keeps uniformity of the pressing force fluctuation, which leads to the tendency that the wavy shape is reduced.

From the viewpoint of obtaining the metal plate 100 with the wavy shape reduced, it is preferable that the pressing force applied to the base material by the rolls should be uniform in the width direction to prevent the pressing force from differing depending on the place where the rolls and the base material come into contact. However, the base material partially has a hard metal tissue or partially has a large thickness in some cases. Therefore, the pressing force applied to the rolls that roll the base material may become nonuniform in the width direction. In order to reduce such nonuniformity of the pressing force, a method such as providing an adjustment mechanism for keeping the pressing force constant at both ends of the roll can be used. This keeps uniformity of the pressing force distribution, which leads to the tendency that the wavy shape is reduced.

The slitting step is a step of cutting both ends of the metal plate 100. This can eliminate cracks that may be caused by rolling at both the ends of the metal plate 100. By carrying out such a slitting step, breakage of the metal plate 100 occurring from a crack, what is called plate cracking, can be reduced. The slitting step may include cutting off both the ends in the width direction of the metal plate 100, respectively, in a predetermined range, thereby adjusting the width of the metal plate 100 to be a desired width.

For example, the metal plate 100 having a total width exceeding 500 mm, for example, a total width of 700 mm may be produced by rolling the base material 55, and thereafter, both the ends in the width direction of the metal plate 100 may be cut to produce the metal plate 100 having the width of 500 mm. At this time, both the ends of the metal plate 100 may be cut equally by 100 mm or may be cut unequally such that a cut width becomes 200 mm in total.

For example, in a case where there is a region having a comparatively large differential expansion rate on one end side of the metal plate 100, the one end side of the metal plate 100 having a total width of 700 mm may be cut wider than the other end side. In a case where a region having a comparatively small differential expansion rate exists with a shift from the center of the metal plate 100 to the one end side, both the ends may be cut such that the portion having a small differential expansion rate becomes the central portion 140 of the metal plate 100 having a width of 700 mm after the slitting step.

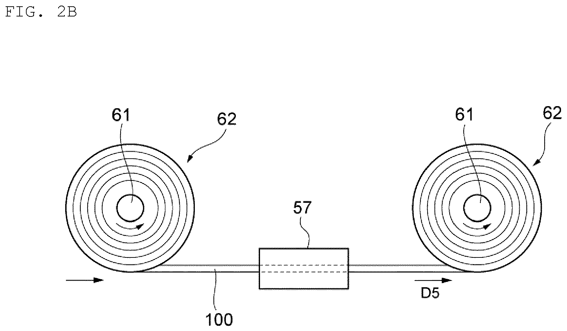

The annealing step is a step of heat-treating the metal plate 100. A residual stress (internal stress) accumulated in the metal plate 100 due to rolling is thereby removed. A heat-treating method is not particularly limited, and as shown in FIG. 2B, for example, the metal plate 100 may be heat-treated using an annealing device 57 in a process of transferring the metal plate 100 in a direction D5 in a roll-to-roll process. On that occasion, heat treatment may be executed while pulling the metal plate 100 in the transfer direction (the longitudinal direction D2). Alternatively, heat treatment may be executed in a batch process in a state where the metal plate 100 has been rolled up around the core 61.

The annealing step may be carried out in a non-reducing atmosphere or an inert gas atmosphere. Herein, the non-reducing atmosphere refers to an atmosphere substantially not containing a reducing gas such as hydrogen. The expression "substantially not containing a reducing gas" means that the concentration of the reducing gas such as hydrogen is 4% or less. The inert gas atmosphere refers to an atmosphere in which an inert gas such as argon gas, helium gas, or nitrogen gas is present by 90% or more. Carrying out the annealing step in the non-reducing atmosphere or the inert gas atmosphere can prevent nickel hydroxide or the like from being produced in the first surface 110 or the second surface 120 of the metal plate 100.

Treatment conditions of the annealing step can be set as appropriate in accordance with the thickness, rolling rate, and the like of the metal plate 100. For example, the treatment conditions of the annealing step may be set at 500°C and 60 seconds.

The rolling step, the slitting step, and the annealing step may be repeated a plurality of times. At that time, these steps may be performed in random order. The method for manufacturing the metal plate of the present disclosure leads to the tendency that the metal plate 100 having a high homogeneity in a wider range can be obtained. Note that the metal plate 100 which is short may be produced by cutting the metal plate 100 which is elongated and configured as described above.

The metal mask of the present disclosure will be described. Note that in the present specification and the present drawings, an example of a metal mask to be used when manufacturing an organic EL display device, and a method for manufacturing the metal mask will be described as one embodiment of the present invention unless otherwise specified.

The metal mask 20 of the present disclosure has the perforated region 22 and a peripheral region 23. The perforated region 22 is a region in which the plurality of through-holes 25 have been formed. The peripheral region 23 is a region positioned around the perforated region 22.

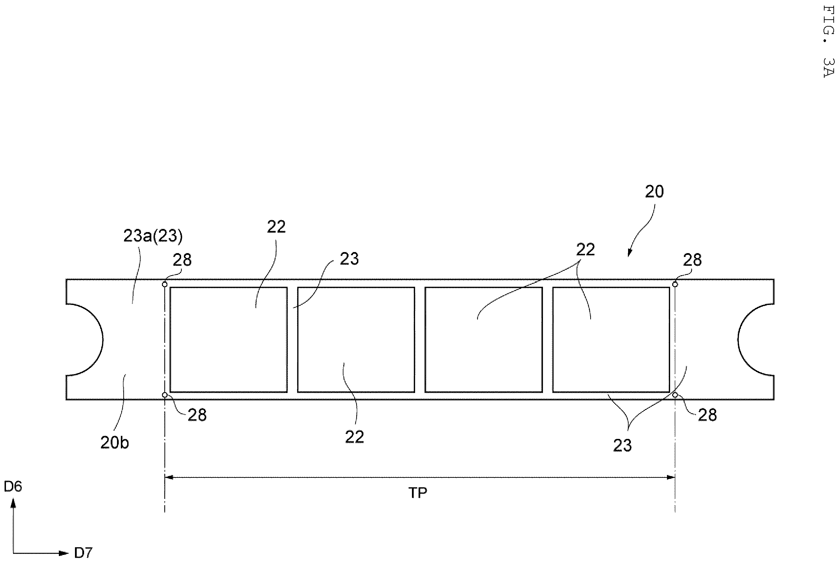

FIG. 3A shows a plan view of the metal mask 20 of one embodiment of the present disclosure on the second surface 20b side. As shown in FIG. 3A, the metal mask 20 may have a generally rectangular contour in plan view. Note that "plan view" in the present disclosure refers to seeing the metal mask 20 from a plane along a plate surface of the metal mask 20.

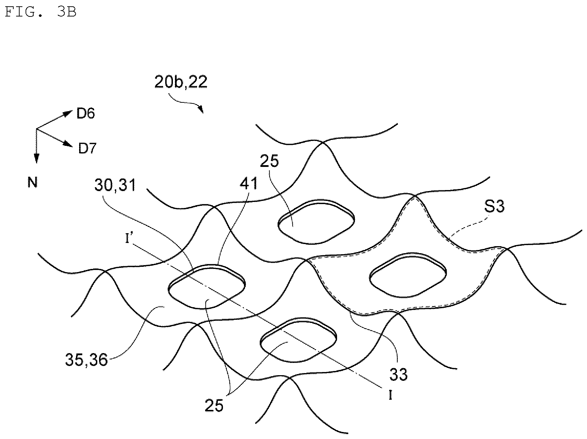

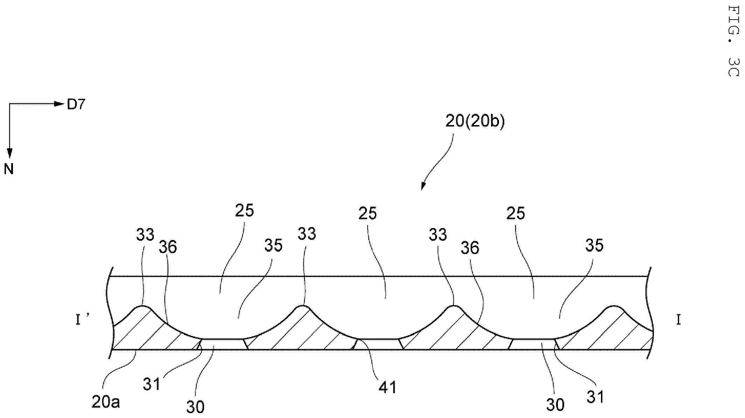

FIG. 3B shows an example of a perspective view of the perforated region 22 as seen from the second surface 20b side. FIG. 3C shows a cross-sectional view of a cross-section I-I shown in FIG. 3B. FIG. 3B and FIG. 3C show an example in which the second wall surfaces 36 of the second recesses 35 of adjacent ones of the through-holes 25 join in the second surface 20b.

As shown in FIG. 3B and FIG. 3C, the through-hole 25 has the first recess 30 formed in the first surface 20a, the second recess 35 formed in the second surface 20b, and a surrounding connecting portion 41 that connects the first recess 30 and the second recess 35. The through-hole 25 is formed by the first recesses 30 on the first surface 20a side and the second recess 35 on the second surface 20b side communicating with each other. A portion where the first recess 30 and the second recess 35 communicate with each other is the connecting portion 41. A first wall surface 31 of the first recess 30 and the second wall surface 36 of the second recess 35 are connected with the surrounding connecting portion 41 interposed therebetween.

An area of the first recess 30 in plan view may gradually decrease from the first surface 20a toward the second surface 20b. An area of the second recess 35 in plan view may gradually decrease from the second surface 20b toward the first surface 20a. The first recess 30 may be configured as a recess smaller in diameter than the second recess 35.

At the connecting portion 41, a direction in which a wall surface of the through-hole 25 spreads changes discontinuously. In general, an opening area of the through-hole 25 in plan view is minimized at the connecting portion 41.

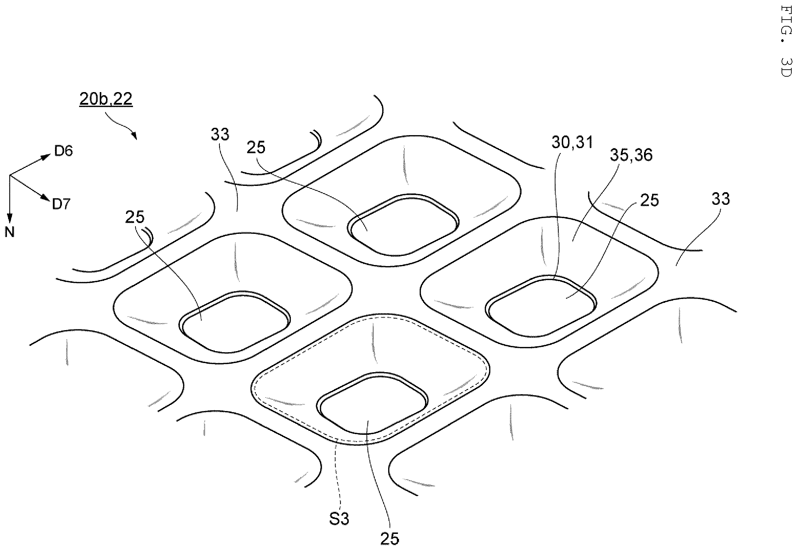

FIG. 3D shows another example of a perspective view of the perforated region 22 as seen from the second surface 20b side. FIG. 3D is an example in which the second wall surfaces 36 of the second recesses 35 of adjacent ones of the through-holes 25 do not join in the second surface 20b.

The metal mask 20 of the present disclosure has the first surface 20a and the second surface 20b as front and rear surfaces. In the present disclosure, the first surface 20a and the second surface 20b of the metal mask 20 are distinguished depending on the diameter of the through-hole 25 in the front and rear surfaces in the perforated region 22. Specifically, as shown in FIG. 3D, the first surface 20a refers to a surface in which the opening area of the through-hole 25 is small in the perforated region 22, and the second surface 20b refers to a surface in which a range S3 of the through-hole 25 is large. In the case where the second wall surfaces 36 of the second recesses 35 of adjacent ones of the through-holes 25 join in the second surface 20b as shown in FIG. 3B, FIG. 3C, and the like, the range S3 closed by a ridge portion 33 surrounding one through-hole 25 may be regarded as the opening of the through-hole 25. In this case, the range closed by the ridge portion 33 is an opening area.

From the viewpoint of the vapor deposition step, the first surface 20a may be a surface of the metal mask 20 that faces the substrate 92 in a case where the metal mask device 10 is stored in a vapor deposition device 90 (see FIG. 6). The second surface 20b may be a surface of the metal mask 20 that is positioned on a crucible 94 side that holds the vapor deposition material 98 in the case where the metal mask device 10 is stored in the vapor deposition device 90 (see FIG. 6).

In the metal mask 20 of the present disclosure, one perforated region 22 may be configured to correspond to one organic EL display device. As shown in FIG. 3A, for example, the metal mask 20 may have a plurality of the perforated regions 22 arranged in line at predetermined intervals in a longitudinal direction D7. The metal mask 20 may also have the perforated regions 22 in a plurality of lines in a width direction D6. In FIG. 3A, the peripheral region 23 is positioned around each of the perforated regions 22. The use of the metal mask 20 enables a plurality of organic EL display devices to be vapor-deposited on the substrate 92 which will be described later.

The perforated regions 22 of the metal mask 20 may have the total pitch marks 28. The total pitch marks 28 are marks provided for evaluating the positional accuracy among the plurality of through-holes 25 in the metal mask 20, and the like.

For example, the total pitch mark 28 may be arranged in the vicinity of a corner of each of the perforated regions 22 and outside the perforated region 22 (in other words, the peripheral region 23), or may be arranged on the inner side of the perforated region 22. The total pitch mark 28 may be formed in a recessed manner at a desired position of the first surface 20a or the second surface 20b by half-etching in a first surface etching step or a second surface etching step which will be described later. Alternatively, a through-hole extending from the first surface 20a to the second surface 20b may be formed and used as the total pitch mark 28. Although FIG. 3A shows an example in which the total pitch mark 28 has a circular planar shape, the total pitch mark is not limited to this and may have an arbitrary shape such as a rectangle.

Note that a "distance TP" shown in FIG. 3A is a distance between the total pitch marks 28 and is a distance between both ends of the perforated regions 22 aligned in the longitudinal direction D7.

The metal mask 20 of the present disclosure is obtained by the method for manufacturing the metal mask according to one embodiment of the present disclosure as will be described later and thus has a tendency that the positional accuracy and dimensional accuracy of the through-holes 25 are favorable.

Subsequently, the method for manufacturing the metal mask according to one embodiment of the present disclosure will be described.

The method for manufacturing the metal mask according to one embodiment of the present disclosure includes a preparation step of preparing the metal plate 100 having the first surface 110 and the second surface 120 positioned opposite to the first surface 110, and an etching step of etching the metal plate 100 to form the above-described metal mask 20. The above-described metal plate 100 is used as the metal plate 100.

Note that although a method for manufacturing the metal mask 20 by etching will be described below, the metal mask 20 may be formed by either etching or laser machining.

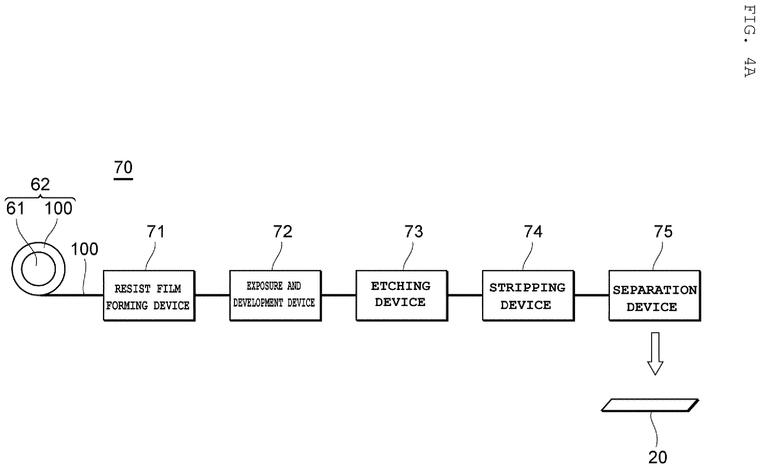

The method for manufacturing the metal mask 20 according to one embodiment of the present disclosure will be described mainly with reference to FIG. 4A to FIG. 4F. FIG. 4A is an outlined view showing a manufacturing apparatus 70 for manufacturing the metal mask 20 using the metal plate 100 together with its processing order. FIG. 4A shows an example in which the metal plate 100 is supplied continuously from a resist film forming device 71 to a stripping device 74. However, the method for manufacturing the metal mask 20 of the present disclosure is not limited to this, and, for example, the metal plate 100 may be rolled up each time it undergoes processing by each of the devices to be brought into a state of a rolled body. When the metal plate 100 is supplied to each of the devices, the metal plate 100 may be pulled out from the rolled body and supplied.

Hereinafter, each step of the method for manufacturing the metal mask 20 will be described in detail.

First, the metal plate 100 having a desired thickness is prepared (the preparation step). The metal plate 100 may be in the state of a rolled body 62 wound around the core 61. The method for fabricating the metal plate 100 having a desired thickness can include, for example, but is not particularly limited to, the above-described rolling method, a plating deposition method, or the like.

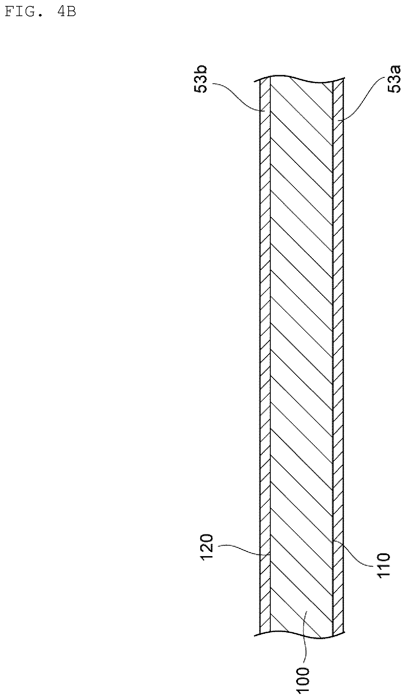

Subsequently, the resist films 53a and 53b are formed on the first surface 110 and the second surface 120 of the metal plate 100 using the resist film forming device 71 (FIG. 4B). Specifically, the resist films 53a and 53b may be formed by bonding a dry film resist to the first surface 110 and the second surface 120. Alternatively, the resist films 53a and 53b may be formed by coating the first surface 110 and the second surface 120 with a coating liquid containing a photosensitive resist material and drying the first surface 110 and the second surface 120.

The dry film resist and the coating liquid are not particularly limited, and conventionally known ones can be used. The resist films 53a and 53b thus formed may be either a negative type resist or a positive type resist. Between them, the negative type resist is preferably used.

The thickness of the resist films 53a and 53b preferably may be 15 µm or less, may be 10 µm or less, may be 6 µm or less, or may be 4 µm or less. The thickness of the resist films 53a and 53b preferably may be 1 µm or more, may be 3 µm or more, may be 5 µm or more, or may be 7 µm or more. The range of the thickness of the resist films 53a and 53b may be determined by a combination of an arbitrary one of the above-described plurality of upper-limit candidate values and an arbitrary one of the above-described plurality of lower-limit candidate values.

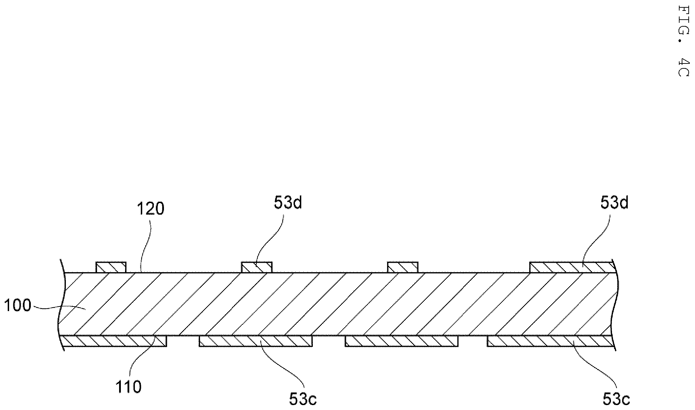

Subsequently, the resist films 53a and 53b are exposed and developed using an exposure and development device 72. This enables a first resist pattern 53c to be formed on the first surface 110 and a second resist pattern 53d to be formed on the second surface 120 as shown in FIG. 4C. In the case where a negative type resist film is used, for example, a photomask configured so as not to let light pass through a to-be-removed region of the resist film may be arranged on the resist film, so that the resist film may be exposed through the photomask, and the resist film may further be developed.

Subsequently, an etching device 73 is used to etch the metal plate 100 using the first resist pattern 53c and the second resist pattern 53d as masks (the etching step). The etching step may include the first surface etching step and the second surface etching step.

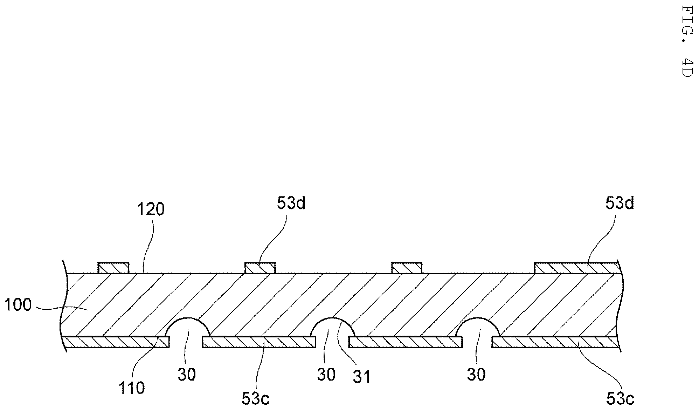

FIG. 4D shows an outlined view representing an example of the first surface etching step in the perforated region 22. In the first surface etching step, regions of the first surface 110 which are not covered by the first resist pattern 53c are etched using an etching solution. On this occasion, the second surface 120 may be covered by resin or the like resistant to the etching solution.

Erosion by the etching solution progresses in the regions of the first surface 110 which are not covered by the first resist pattern 53c (FIG. 4D). A large number of the first recesses 30 are thereby formed in the first surface 110. Note that etching of the metal plate 100 may progress isotropically in various directions from holes of the resist pattern. Thus, the first recess 30 and the second recess 35 are shaped such that their cross sectional areas at each position in the thickness direction of the metal mask 20 gradually decrease with progress in the thickness direction from the surfaces.

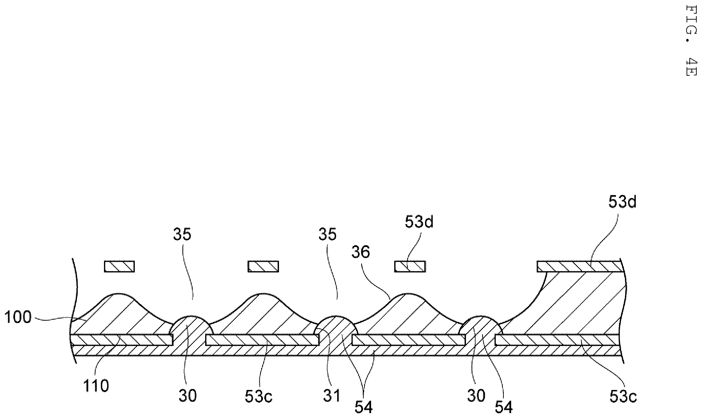

FIG. 4E shows an outlined view representing an example of the second surface etching step in the perforated region 22. In the second surface etching step, the regions of the second surface 120 which are not covered by the second resist pattern 53d are etched using the etching solution. On this occasion, the film or the like covering the second surface 120 in the first surface etching step may be stripped in advance. The first surface 110 may be covered by a resin 54 or the like resistant to the etching solution.

Erosion by the etching solution progresses in the regions of the second surface 120 which are not covered by the second resist pattern 53d (FIG. 4E). The second recesses 35 are thereby formed in the second surface 120. The first recess 30 and the second recess 35 then communicate with each other, thereby forming the through-hole 25.

The etching solution is not particularly limited as long as it is conventionally known, and examples thereof can include a solution containing a ferric chloride solution and hydrochloric acid.

In the second surface etching step, etching may progress until adjacent ones of the second recesses 35 are connected to each other as shown in FIG. 4E. At a location where adjacent ones of the second recesses 35 are connected to each other, the adjacent ones of the second recesses 35 join to form the ridge portion 33. The ridge portion 33 is spaced from the second resist pattern 53d, and erosion by etching also progresses in the thickness direction of the metal plate 100 at a top of the ridge portion 33. The second resist pattern 53d is thereby stripped from the metal plate 100. Note that the second surface 120 may be partially left between adjacent ones of the second recesses 35.

Furthermore, the resist patterns and the resin 54 or the like resistant to the etching solution are stripped from the metal plate 100 using the stripping device 74. Then, a separation step of cutting the elongated metal plate 100 using a separation device 75, thereby separating the metal mask 20 formed of a sheet-like metal plate from the metal plate 100 is performed. The metal mask 20 can be obtained in this manner.

According to such a method for manufacturing the metal mask 20, the use of the above-described metal plate 100 leads to a tendency that a metal mask excellent in positional accuracy and dimensional accuracy of the through-holes can be obtained.

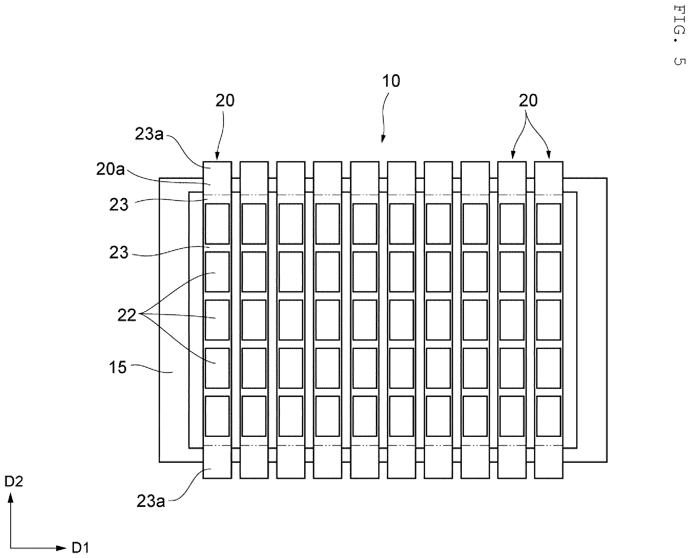

The metal mask device 10 according to one embodiment of the present disclosure includes the frame 15 and the above-described metal mask 20 installed on the frame 15. The metal mask 20 may be installed on the frame 15 with the second surface 20b in contact with the frame 15. FIG. 5 shows a plan view of the metal mask device 10 as seen from the first surface 20a side of the metal mask 20. FIG. 6 shows a cross-sectional view representing the vapor deposition device.

In the metal mask device 10 of the present disclosure, a plurality of the metal masks 20 may be attached to one frame (FIG. 5). In this case, the plurality of metal masks 20 may be aligned in the width direction D1 crossing the longitudinal direction D2 of the metal mask 20. Each of the metal masks 20 may be fixed to the frame 15 at both end portions 23a in the longitudinal direction D2 of the metal mask 20.

A method for fixing the metal masks 20 to the frame 15 can include, for example, but is not particularly limited to, welding and the like.

The metal mask device 10 may include a member fixed to the frame 15 and partially overlapped on the metal masks 20 in the thickness direction of the metal masks 20. Such a member can include, for example, but is not particularly limited to, a member extending in the direction crossing the longitudinal direction of the metal masks 20 and supporting the metal masks 20, a member overlapped on a gap between adjacent two metal masks, and the like.

Next, a method for manufacturing an organic EL display device using the metal mask 20 according to the present disclosure will be described with reference to FIG. 6. The organic EL display device may include, in a stacked state, the substrate 92 and a vapor deposition layer including the vapor deposition material 98 provided in a pattern shape.

The method for manufacturing the organic EL display device of one embodiment of the present disclosure can include, for example, but is not particularly limited to, a vapor deposition step of vapor-depositing the vapor deposition material 98 on a substrate such as the substrate 92 using the metal mask 20.

In the vapor deposition step, the metal mask device 10 is arranged first such that the metal mask 20 is opposed to the substrate 92. On this occasion, the first surface 20a of the metal mask 20 may be opposed to the substrate 92 as shown in FIG. 6. Herein, the substrate 92 is an evaporation target such as a glass substrate.

In a case where the metal mask device 10 is stored in the vapor deposition device 90 as shown in FIG. 6, a surface of the metal mask 20 facing the substrate 92 is the first surface 20a, and a surface of the metal mask 20 positioned on the crucible 94 side that holds the vapor deposition material 98 is the second surface 20b. In the vapor deposition device 90, the metal mask 20 is located on a surface of the substrate 92 on the crucible 94 side. Herein, the metal mask 20 and the substrate 92 may be brought into close contact with each other by a magnetic force.

In the vapor deposition device 90, the crucible 94 that stores the vapor deposition material 98 and a heater 96 that heats the crucible 94 may be arranged below the metal mask device 10. Herein, the vapor deposition material 98 may be an organic light emitting material as an example. The vapor deposition material 98 in the crucible 94 is vaporized or sublimated by heating of the heater 96. The vaporized or sublimated vapor deposition material 98 adheres to the substrate 92 by way of the through-holes 25 of the metal mask 20. The vapor deposition material 98 is thereby deposited on the surface of the substrate 92 in a desired pattern corresponding to the position of the through-holes 25 of the metal mask 20. Note that in the vapor deposition step, the inside of the vapor deposition device 90 may be brought into a vacuum atmosphere.

In a case of intending to vapor-deposit different types of vapor deposition materials in accordance with pixels such as RGB, the vapor deposition material 98 may be deposited on the surface of the substrate 92 using different metal masks 20 in accordance with colors of the vapor deposition material 98. For example, the vapor deposition material 98 for red, the vapor deposition material 98 for green, and the vapor deposition material 98 for blue may be sequentially deposited on the substrate 92. Alternatively, the metal mask 20 (the metal mask device 10) and the substrate 92 may be relatively moved little by little in an array direction (the aforementioned one direction) of the through-holes 25 to sequentially deposit the vapor deposition material 98 for red, the vapor deposition material 98 for green, and the vapor deposition material 98 for blue.

The method for manufacturing the organic EL display device may include various steps in addition to the vapor deposition step of vapor-depositing the vapor deposition material 98 on the substrate such as the substrate 92 using the metal mask 20. For example, the method for manufacturing the organic EL display device may include a step of forming a first electrode on the substrate. The vapor deposition layer is formed on the first electrode. The method for manufacturing the organic EL display device may also include a step of forming a second electrode on the vapor deposition layer. The method for manufacturing the organic EL display device may also include a sealing step of sealing the first electrode, the vapor deposition layer, and the second electrode provided on the substrate 92.

The vapor deposition layer formed on the substrate such as the substrate 92 using the metal mask 20 is not limited to the light emitting layer formed by vapor deposition of the above-described organic light emitting material, and may include other layers. For example, the vapor deposition layer may include a hole injection layer, a hole transport layer, a light emitting layer, an electron transport layer, an electron injection layer, and the like in this order from the first electrode side. In this case, the vapor deposition step through use of the metal mask 20 corresponding to each of the layers may be performed.

According to the method for manufacturing the organic EL display device of the present disclosure, the use of the above-described metal mask 20 leads to the tendency that an organic EL display device excellent in dimensional accuracy and positional accuracy of pixels can be obtained.

### EXAMPLES

Hereinafter, the present invention will be described more specifically using examples and comparative examples. The present invention is not limited at all by the following examples.

### (First Sample)

First, the rolling step, the slitting step, and the annealing step described above were carried out on a base material made of an invar material to manufacture a plurality of rolled bodies obtained by rolling up elongated metal plates.

Specifically, a first rolling step of performing a first hot-rolling step and a first cold-rolling step in this order was carried out first. Next, a first slitting step of cutting off both ends in the width direction of the elongated metal plate, respectively, in a range of 3 to 5 mm was carried out. Thereafter, a first annealing step of continuously annealing the elongated metal plate at 500°C for 60 seconds was carried out.

Furthermore, a second rolling step including a second cold-rolling step was carried out on the elongated metal plate undergone the first annealing step. Next, a second slitting step of cutting off both ends in the width direction of the elongated metal plate, respectively, in a range of 3 to 5 mm was carried out. Thereafter, a second annealing step of continuously annealing the elongated metal plate at 500°C for 60 seconds was carried out.

The metal plate having a desired thickness and a width of 600 mm was thereby obtained. Thereafter, a slitting step of cutting off both the ends in the width direction of the metal plate, respectively, in a predetermined range, thereby finally adjusting the width of the metal plate to a desired width, specifically, a width of 500 mm was carried out.

Note that the cold-rolling step was performed using a rolling oil while cooling the metal plate. After the cold-rolling step, a cleaning step of cleaning the elongated metal plate with a hydrocarbon-based cleaning agent was performed. After the cleaning step, the slitting step, the annealing step, and the slitting step described above were carried out. Thereafter, a leading end part of the rolled body was cut off to obtain a first sample made of an elongated metal plate having a width of 500 mm and a length of 600 m.

In measurement, a ranging device through use of laser light was first moved relatively on a first sample in the longitudinal direction D2 as indicated by arrows in FIG. 1G to continuously measure a height position of a surface of the first sample in the longitudinal direction. By performing the measurement while shifting the ranging device in the width direction, a height profile of a wavy shape of the first sample was obtained. Then, a profile of the differential expansion rate En in the unit length L0 in the longitudinal direction with respect to the arbitrary position n in the width direction of the metal plate was obtained based on the height profile. As the ranging device, a compact, ultrahigh precision sensor head (model number: LK-G15A) manufactured by KEYENCE CORPORATION was employed and used for the measurement.

A measurement interval of the height profile was set at an 8-mm interval in the width direction D1 and a 10-mm interval in the longitudinal direction D2. The measurement was performed with the unit length L0 set at three different lengths of 750 mm, 1280 mm, and 3000 mm. Note that, for this unit length L0 (750 mm, 1280 mm, or 3000 mm), a metal mask of a larger product size is assumed.

### (Second Sample to Fifth Sample)

Similarly to the case of the first rolled body, a second rolled body to a fifth rolled body were manufactured from a base material made of an invar material. Furthermore, for the second rolled body to the fifth rolled body, the differential expansion rates of a second sample to a fifth sample taken out from the respective rolled bodies were measured similarly to the case of the first rolled body.

Note that for the second rolled body, pressure adjustment was performed such that the pressing force did not fluctuate comparatively in accordance with the passage of the base material in the hot-rolling step and cold-rolling step described above.

For the third rolled body, pressure adjustment was performed such that fluctuation in the pressing force in accordance with the passage of the base material was reduced as compared with that when the second rolled body was manufactured.

For the fourth rolled body, pressure adjustment was performed such that fluctuation in the pressing force in accordance with the passage of the base material was reduced similarly to that when the third rolled body was manufactured, and furthermore, the pressing force to be applied to the base material was made comparatively uniform in the width direction.

For the fifth rolled body, pressure adjustment was performed such that fluctuation in the pressing force in accordance with the passage of the base material was reduced similarly to that when the third rolled body was manufactured, and furthermore, uniformity in the width direction of the pressing force to be applied to the base material was improved as compared with that when the fourth rolled body was manufactured.

Note that by reducing fluctuation in the pressing force in accordance with the passage of the base material as compared with that when the second rolled body was manufactured, the differential expansion rate in the central portion was able to be reduced to be small as a whole in manufacturing of the third rolled body, and the differential expansion rate in the central portion had a small maximum value.

### (Metal Mask)

The metal mask was produced from each of the metal plates 100 of the first rolled body to the fifth rolled body using the above-described method for manufacturing the metal mask. In other words, the through-holes were formed, and the metal mask was obtained. Here, the metal mask whose dimension in the width direction D1 was 67 mm and in which the distance between both the ends of the perforated regions aligned in the longitudinal direction D2 was 750 mm and 1280 mm was produced.

The metal masks were installed on the frame as shown in FIG. 5 with tension being applied as shown in FIG. 1F to produce a vapor deposition mask device. Then, first surfaces of the metal masks in the vapor deposition mask device were brought into close contact with a substrate for deposition having dimensions of 900 mm × 1500 mm when seen in plan view, having a thickness of 0.5 mm, and made of alkali-free glass. Thereafter, a vapor deposition material made of an organic light emitting material was vapor-deposited on the substrate for deposition through the through-holes formed in the respective metal masks. After removing the vapor deposition mask from the substrate for deposition, the positional accuracy of the vapor deposition material when the metal masks were laid under tension was evaluated.

The positional accuracy of the vapor deposition material when the metal masks were laid under tension was evaluated with a two-dimensional coordinate size measuring instrument. In the evaluation of the positional accuracy, rolled bodies having high positional accuracy of the vapor deposition material in each pixel were evaluated as "A", and rolled bodies having low positional accuracy of the vapor deposition material in each pixel were evaluated as "C".

Table 1 shows the maximum value of the inclination of the differential expansion rate En in the central portion of the metal plate, the maximum value of the differential expansion rate in the central portion, the maximum values of the differential expansion rates in both the side portions, and a result of the positional accuracy when the metal masks were laid under tension as described above.

**[Table 1]**

| | | Measured length (mm) | Maximum value of inclination of differential expansion rate En in central portion | Maximum value of differential expansion rate En in central portion | Maximum values of differential expansion rates in both side portions | | positional accuracy when metal masks were laid under tension |
|---|---|---|---|---|---|---|---|
| | | | | | One side | The other side | |
| Comparative Example 1 | First rolled body | 750 | 2.1×10^{*-*3}/m | 2.7×10⁻⁵ | 7.5×10⁻⁵ | 8.3×10⁻⁵ | C |
| | | 1280 | 2.1×10^{*-*3}/m | 2.8×10⁻⁵ | 7.5×10⁻⁵ | 8.3×10⁻⁵ | C |
| | | 3000 | 2.1×10^{*-*3}/m | 2.8×10⁻⁵ | 7.5×10⁻⁵ | 8.3×10⁻⁵ | - |
| Comparative Example 2 | Second rolled body | 750 | 2.3×10⁻³/m | 2.8×10⁻⁵ | 6.7×10⁻⁵ | 6.3×10⁻⁵ | C |
| | | 1280 | 2.3×10⁻³/m | 2.7×10⁻⁵ | 6.7×10⁻⁵ | 6.2×10⁻⁵ | C |
| | | 3000 | 2.3×10⁻³/m | 2.7×10⁻⁵ | 6.7×10⁻⁵ | 6.2×10⁻⁵ | - |
| Comparative Example 3 | Third rolled body | 750 | 2.0×10⁻³/m | 2.6×10⁻⁵ | 6.5×10⁻⁵ | 7.0×10⁻⁵ | C |
| | | 1280 | 1.9×10⁻³/m | 2.6×10⁻⁵ | 6.5×10⁻⁵ | 7.0×10⁻⁵ | C |
| | | 3000 | 1.9×10⁻³/m | 2.6×10⁻⁵ | 6.5×10⁻⁵ | 7.0×10⁻⁵ | - |
| Example 1 | Fourth rolled body | 750 | 1.7×10⁻³/m | 2.4×10⁻⁵ | 5.6×10⁻⁵ | 5.9×10⁻⁵ | A |
| | | 1280 | 1.7×10⁻³/m | 2.4×10⁻⁵ | 5.5×10⁻⁵ | 5.9×10⁻⁵ | A |
| | | 3000 | 1.7×10⁻³/m | 2.4×10⁻⁵ | 5.5×10⁻⁵ | 5.9×10⁻⁵ | - |
| Example 2 | Fifth rolled body | 750 | 1.5×10⁻³/m | 2.1×10⁻⁵ | 5.1×10⁻⁵ | 5.7×10⁻⁵ | A |
| | | 1280 | 1.5×10⁻³/m | 2.1×10⁻⁵ | 5.0×10⁻⁵ | 5.7×10⁻⁵ | A |
| | | 3000 | 1.5×10⁻³/m | 2.1×10⁻⁵ | 5.0×10⁻⁵ | 5.7×10⁻⁵ | - |

| | | | | | | | |
|---|---|---|---|---|---|---|---|
| -: not measured | | | | | | | |

Note that in Examples 1 and 2, the maximum values of the differential expansion rates En in the two side portions in the width direction D1 were each larger than the maximum value of the differential expansion rate En in the central portion in the width direction D1 as shown above.

In the examples and comparative examples, the maximum value of the inclination of the differential expansion rate En in the central portion of the metal plate was also measured with the unit length L0 set at 500 mm. As a result, the maximum value of the inclination of the differential expansion rate En in the central portion of the metal plate with the unit length L0 set at 500 mm was as a whole larger than the maximum value of the inclination of the differential expansion rate En in the central portion of the metal plate with the unit length L0 set at 750 mm, 1280 mm, or 3000 mm. It was not considered that the maximum value of the inclination of the differential expansion rate En in the central portion of the metal plate with the unit length L0 set at 750 mm, 1280 mm, or 3000 mm was predictable from the maximum value of the inclination of the differential expansion rate En in the central portion of the metal plate with the unit length L0 set at 500 mm.

In the examples and the comparative examples, the maximum value of the differential expansion rate in the central portion was also measured with the unit length L0 set at 500 mm. As a result, the maximum value of the inclination of the differential expansion rate En in the central portion of the metal plate with the unit length L0 set at 500 mm was larger in some cases and smaller in other cases than the maximum value of the inclination of the differential expansion rate En in the central portion of the metal plate with the unit length L0 set at 750 mm, 1280 mm, or 3000 mm. This is inferred because the degree of waves shown in FIG. 1A and FIG. 1B included in the unit length L0 differs by setting the unit length L0 long. Also in this case, it was not considered that the maximum value of the differential expansion rate in the central portion with the unit length L0 set at 750 mm, 1280 mm, or 3000 mm was predictable from the maximum value of the differential expansion rate in the central portion of the metal plate with the unit length L0 set at 500 mm.

### Industrial Applicability

The present invention has industrial applicability as a metal plate which is to be used for manufacturing a metal mask.

### Reference Signs List

- 10: metal mask device
- 15: frame
- 20: metal mask
- 20a: first surface
- 20b: second surface
- 22: perforated region
- 23: peripheral region
- 23a: end portion
- 23b: side
- 25: through-hole
- 27: outer shape
- 28: total pitch mark
- 30: first recess
- 31: first wall surface
- 33: ridge portion
- 35: second recess
- 36: second wall surface
- 41: connecting portion
- 53a: resist film
- 53b: resist film
- 53c: first resist pattern
- 53d: second resist pattern
- 54: resin
- 55: base material
- 56a: rolling roll
- 56b: rolling roll
- 57: annealing device
- 61: core
- 62: rolled body
- 70: manufacturing apparatus
- 71: resist film forming device
- 72: exposure and development device
- 73: etching device
- 74: stripping device
- 75: separation device
- 86: clamp
- 90: vapor deposition device
- 92: substrate
- 94: crucible
- 96: heater
- 98: vapor deposition material
- 100: metal plate
- 110: first surface
- 120: second surface
- 130: side edge
- 131: side
- 140: central portion
- 150: side portion

## Claims

1. A metal plate to be used for manufacturing a metal mask, wherein
in a graph in which an arbitrary position n in a width direction of the metal plate is plotted on a horizontal axis and in which a differential expansion rate En in a unit length L0 in a longitudinal direction is plotted on a vertical axis,
a maximum inclination of the differential expansion rate E in a central portion in the width direction is 1.8 × 10⁻³/m or less, and
the central portion is a portion that occupies 80% in the width direction excluding both side portions that each occupy 10% in the width direction.

2. The metal plate according to claim 1, wherein a maximum value of the differential expansion rate En in the central portion in the width direction is 2.5 × 10⁻⁵ or less.

3. The metal plate according to claim 1, wherein a maximum value of the differential expansion rate En in the side portions is 2.5 × 10⁻⁵ or more.

4. The metal plate according to claim 1, wherein the metal plate has a thickness of 50 µm or less.

5. The metal plate according to claim 1, wherein the unit length L0 in the longitudinal direction of the metal plate is 0.5 m or more and 3.0 m or less.

6. A method for manufacturing a metal plate to be used for manufacturing a metal mask, the method comprising
a rolling step of rolling a base material to obtain the metal plate, wherein
in the metal plate,
in a graph in which an arbitrary position n in a width direction of the metal plate is plotted on a horizontal axis and in which a differential expansion rate En in a unit length L0 in a longitudinal direction is plotted on a vertical axis,
a maximum inclination of the differential expansion rate E in a central portion in the width direction is 1.8 × 10⁻³/m or less, and
the central portion is a portion that occupies 80% in the width direction excluding both side portions that each occupy 10% in the width direction.

7. A method for manufacturing a metal mask, comprising:
a rolling step of rolling a base material to prepare a metal plate; and
an etching step of etching the metal plate to form the metal mask, wherein
in the metal plate,
in a graph in which an arbitrary position n in a width direction of the metal plate is plotted on a horizontal axis and in which a differential expansion rate En in a unit length L0 in a longitudinal direction is plotted on a vertical axis,
a maximum inclination of the differential expansion rate E in a central portion in the width direction is 1.8 × 10⁻³/m or less, and
the central portion is a portion that occupies 80% in the width direction excluding both side portions that each occupy 10% in the width direction.
